# EUROPEAN PATENT SPECIFICATION

(11) **EP 3 726 682 B1**
(45) Date of publication and mention of the grant of the patent: **13.12.2023**
(21) Application number: 18889156.8
(22) Date of filing: 30.09.2018
(51) Int. Cl.: H02H 9/06, H01T 4/12, H01T 1/12, H01T 1/14, H01T 1/16, H01T 4/06, G01R 19/165

(54) **SECURITY UNIT**
SICHERUNGSEINHEIT
UNITÉ DE SÉCURITÉ

(30) Priority: 15.12.2017 CN 201711352260
(43) Date of publication of application: 21.10.2020
(73) Proprietor: Nanjing Zhongxing Software Company Limited., Jiangsu 210012 (CN)
(72) Inventor: TANG, Rongdao, Nanjing, Jiangsu 210012 (CN)
(74) Representative: GLP S.R.L.
(86) International application number: PCT/CN2018/109004
(87) International publication number: WO 2019/114377

(56) References cited:
- CN-A- 1 505 231
- CN-A- 1 527 455
- CN-A- 1 527 455
- CN-A- 1 878 323
- CN-A- 101 752 858
- CN-A- 105 826 149
- CN-A- 106 451 397
- CN-U- 204 407 882
- CN-Y- 2 612 136
- US-A1- 2016 358 721

## Description

### Field of the Invention

This application relates to the field of communication technologies, and in particular to a security unit.

### Background of the Invention

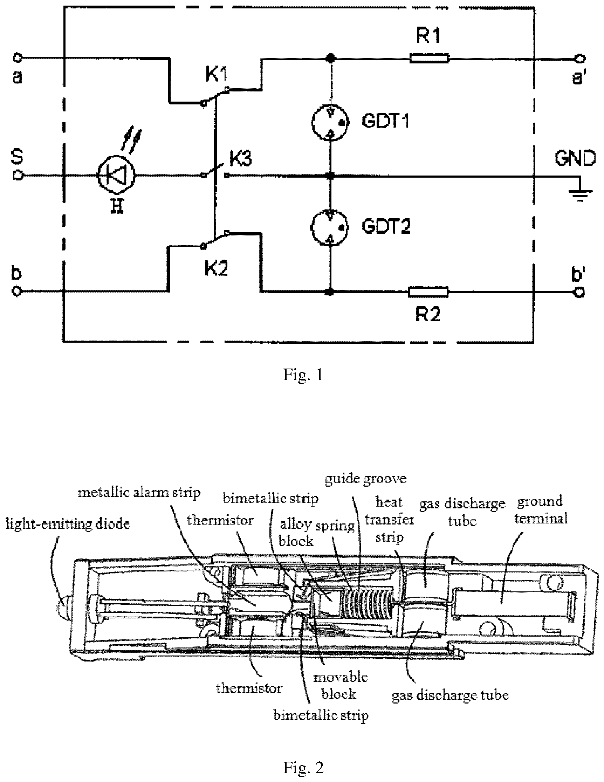

A security unit in a distribution frame has overvoltage and overcurrent protection effectsin a communication line, and also has an alarm function when an abnormal voltage is present on an external line.Fig. 1 is a schematic diagram showing a circuit of a security unit in a related art, in which a and b are external line terminals of the security unit; a'and b' are internal line terminals of the security unit; S is an alarm signal terminal of the security unit; and GND is a ground terminal of the security unit. Overcurrent protection components R1 and R2 are positive temperature coefficient (PTC)thermistors.Overvoltage protection components GDT1 and GDT2 are gas discharge tubes (GDTs). K1 and K2 are normally closed main circuit breakers which are usually bimetallic strips. The main circuit is disconnected when the bimetallic strip is overheated and deformed. K3 is a normally open alarm switch, which is linked with K1 and K2. When an overvoltage occurs, the switch is switched to protective ground, and in the case that an external current-limiting power is applied to S pin and GND, a light-emitting diode H can be illuminated.

When an external abnormal voltage causes a voltage across two electrodes of the gas discharge tube to exceed a breakdown voltage of a gas, it results in a gap discharge. In this case, the gas discharge tube quickly switches from a high-impedance state to a low-impedance state and becomes conductive,thus protecting other circuits connected thereto in parallel.If this overvoltage lasts for a long time, the gas discharge tube gets hot and heated due to an effect of a long-term or frequent overcurrent, which causes the bimetal strip to be overheated and deformed andto thereby disconnect the main circuit. In the case of mass production, due to differences in uniformities of production processes, devices, and assembly, it is often difficult to achieve satisfactory cooperation between the getting hot of the gas discharge tube and the disconnecting of the main circuit by the bimetallic strip, which leads to a risk of developing a short circuit in the gas discharge tube or bursting of the gas discharge tube, or even the burning of a component of the security unit which may cause a fire.

CN204407882U discloses a lightning protector for a non-grounded LED lamp power source.

CN101752858A discloses an overvoltage protection module for power source of multi-gap metal gas discharge tube.

CN105826149A discloses a gas discharge tube. It comprises at least two electrodes and an isolating tube formed as an inner-chamber for the discharge. The isolating tube is connected seamlessly to the at least two electrodes.

CN1527455A discloses a new protection circuit. The protection circuit is designed to prevent burning the distribution frame and the outside cable during commercial electricity connection, regardless the length of the outside cable and the size of the line resistance.

### Summary of the Invention

The present invention provides a security unit which can avoid the risk of a short circuit or bursting caused by overheating due to a long-lasting overcurrent.

The present invention, which is defined by the appended claims, provides a security unit including an overvoltage protection circuit and an alarm indication circuit connected in parallel.

An initial state of the overvoltage protection circuit is a high-impedance state. The overvoltage protection circuit switches to a conductive state when a voltage across two ends thereof is greater than a breakdown voltage, and switches to an open-circuit state when a current flowing thereinto is greater than a current threshold and duration of the current exceeds a time threshold.

The alarm indication circuit outputs an alarm signal when a voltage across two ends thereof is greater than a voltage threshold.

The alarm indication circuit comprises a first current-limiting module, a second current-limiting module, and an alarm module. The first current-limiting module and the second current-limiting module are connected in series. One end of the alarm module is connected between the first current-limiting module and the second current-limiting module, and another end thereof is grounded.

In some of the embodiments of the present invention, the overvoltage protection circuit in the security unit can meet reliability standards of related power lines, lightning surges and so on. When a lightning surge and a surge current occur, the overvoltage protection circuit can quickly discharge a large current. When a current flowing into the overvoltage protection circuit is greater than a current threshold and duration thereof exceeds a time threshold, the overvoltage protection circuit switches to an open-circuit state, which can effectively prevent risks such as bursting of the gas discharge tube caused by its getting heated due to a gas breakdown and its becoming conductive, as well as burning of the security unit. In the case of an abnormal hazardous voltage such as power line bonding or power line induction, the alarm indication circuit in the security unit can illuminate a lamp for alarm about power line bonding without requiring an external power supply such as -48V.The security unit also has functions of a conventional security unit and can output a power line bonding alarm signal to a network manager with the addition of an external current-limiting resistor power supply of -48 V. In addition, all components of the security unit can be weldedon a printed board, anddevices such asa bimetallic strip and a spring are omitted, which further reduces the cost and is more suitable for mass production.

In one embodiment of the present invention, the security unit adopts an overcurrent protection circuit. By using a positive temperature coefficient thermistor, the overcurrent protection circuit limits an external hazardous current to flow into a protected subscriber terminal when an external hazardous voltage continues to appear, and meanwhile decouples the security unit from a protected terminal secondary protection circuit in the case of a rapid pulse interference such as a surge.

### Brief Description of the Drawings

The drawings are provided for a further understanding of technical solutions of the present invention. The drawings,together with the embodiments of the present invention, are used to explain rather than limit the technical solutions of the present disclosure.
Fig. 1 is a schematic diagram showing a circuit of a security unit in a related art;
Fig.2 is a schematic diagram showinga structure of the security unit in the related art;
Fig. 3 is a schematic diagram showing components of a security unit according to an embodiment of the present disclosure;
Fig. 4 is a schematic diagram showing components of an alarm indication circuit according to an embodiment of the present disclosure;
Fig. 5 is a schematic diagram showing components of a security unit according to another embodiment of the present disclosure;
Fig. 6 is a schematic diagram showing a first application example of the presentdisclosure;
Fig. 7 is a schematic diagram showing a second application example of the presentdisclosure;
Fig. 8 is a schematic diagram showing a thirdapplication example of the presentdisclosure;
Fig. 9 is a schematic diagram showing a fourth application example of the presentdisclosure; and
Fig. 10 is a schematic diagram showing a fifth application example of the presentdisclosure.

### Detailed Description of the Embodiments

To make the objectives,technical solutions, and advantages of the present disclosure clearer, the embodiments of the present disclosure will be described in detail below with reference to the drawings.It should be noted that the embodiments in the present disclosure and features in the embodiments can be arbitrarily combined with each other as long as there is no conflict.

Steps shown in a flowchart in the drawings can be performed in a computer system such as a set of computer-executable instructions. Also, although a logical order is shown in a flowchart, in some cases, steps shown or described may be performed in an order different from the order described herein.

A structure of a security unit in a related art is shown in Fig. 2. The structure is relatively complex. The security unit includes a gas discharge tube, a heat transfer strip, a spring, a low-melting-point alloy block, a movable block, and a bimetallic strip, in addition to a housing. The use of the gas discharge tube may lead to a risk of a short circuit or bursting.Besides,manual assembly of such a security unit requires a lot of work, and price of the bimetallic strip is high, which can result in a relatively high cost of the entire security unit.

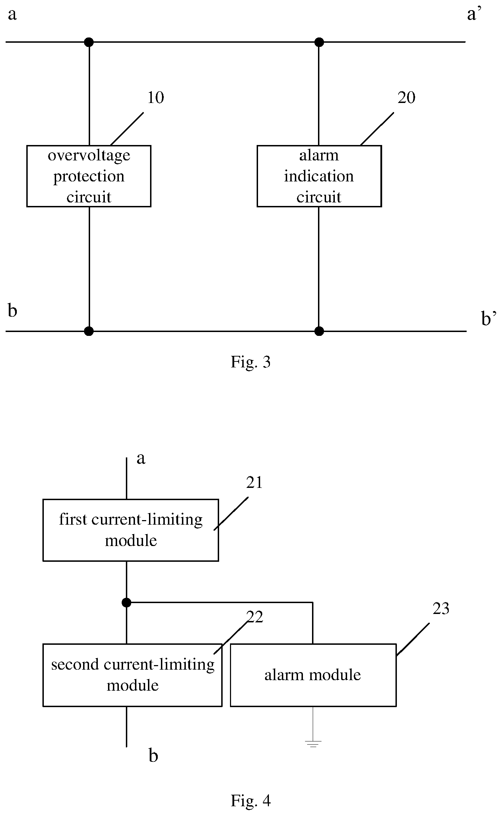

A security unit provided byan embodiment of the present disclosure is shown in Fig. 3 terminal a and terminal b are external line terminals, for connecting an outdoor subscriber line, and terminal a' and terrminal b' are internal line terminals, for,after being protected by the security unit, connecting a subscriber line of a central office device. The security unit of the present embodiment includes an overvoltage protection circuit 10 and an alarm indication circuit 20 connected in parallel.

An initial state of the overvoltage protection circuit 10 is a high-impedance state. When a voltage across two ends of the overvoltage protection circuit 10 is greater than a breakdown voltage, the overvoltage protection circuit 10 switches from the high-impedance state to a conductive state. When a current flowing into the overvoltage protection circuit 10 is greater than a current threshold and duration thereof exceeds a time threshold, the overvoltage protection circuit 10 switches to an open-circuit state.

The alarm indication circuit 20 is in a high-impedance state. When a voltage acrosstwo ends of the alarm indication circuit 20is greater than a voltage threshold of a threshold switch, an alarm indication sub-module and an alarm signal output sub-module output an alarm signal.The threshold switch may be formed from an overvoltage protector (for example, a semiconductor overvoltage protector), a transient suppression diode, a varistor, or a zener diode.

In the present embodiment, the overvoltage protection circuit in the security unit can meet reliability standards of related power lines, lightning surges and so on. When a lightning surge and a surge current occur, the overvoltage protection circuit can quickly discharge a large current. When acurrent flowing into the overvoltage protection circuit is greater than a current threshold and duration thereof exceeds a time threshold, the overvoltage protection circuit switches to an open-circuit state, which can effectively prevent riskssuch as bursting of the gas discharge tube caused by its gettingheated due to agas breakdown and its becoming conductive, as well as burning of the security unit.

In one embodiment, the overvoltage protection circuit 10 includes at least one open-circuit-failure-type gas discharge tube.

In the case of an overvoltage condition, an ordinary gas discharge tube gets heated due to a gas breakdown. If the overvoltage lasts for a long time, the gas discharge tube will burn out.The open-circuit-failure-type gas discharge tube, however, can discharge a lightning current when a lightning strike or a surge overvoltage occurs. Under an abnormal condition wherean internal gas breaks down for a long time, a low-temperature sealing adhesive between an electrode and an insulating tube of the open-circuit-failure-type gas discharge tube melts,which results in failure ofa sealing state. In this case, external airquickly enters the open-circuit-failure-type gas discharge tubeand contacts the discharge emitting surfaceof the gas discharge tube for airblowout and quickly cuts off a subsequent current, thereby preventing risks of bursting of the gas discharge tube and burning of the security unit.

In one embodiment, the overvoltage protection circuit 10 includes two two-electrode open-circuit-failure-type gas discharge tubes connected in series.The connection point between the two two-electrode open-circuit-failure-type gas discharge tubes is grounded.Or, the overvoltage protection circuit includes onethree-electrode open-circuit-failure-type gas discharge tube.

The low-temperature sealing adhesive in the open-circuit-gas-dischargetube, witha properly selected melting heat energy value (I2t), can meet a related reliability standard.If the current exceeds 1A, the time threshold can be set to more than 0.2 seconds, and a DC breakdown voltage of the discharge tube is greater than a rated voltage for power line bonding specified by a related standard such as ITU (International Telecommunications Union) K20 and smaller than a standard power line induction test voltage. This can ensure that the open-circuit-failure-type gas discharge tube is in a high-impedance state when apower line is bonded. During apower line induction test, a gas inside the discharge tube breaks down and the discharge tube can withstand a 1A induction current specified by the ITU standard within 0.2 seconds. Once the induction current continues to be greater than 1A,the low-temperature sealing adhesive melts rapidlyin a few seconds, causing the gas discharge tube to be in an open-circuit state.

It should be noted that, in the embodiments of the present disclosure, the current threshold, the time threshold, the breakdown voltage, and the voltage threshold can be set according to actual conditions, and an open-circuit-failure-type gas discharge tube can be selectedcorrespondingly.Theseare not limited to the above examples.

Forms of packaging the open-circuit-failure-type gas discharge tube include pin packaging and chip packaging. In the case of pin packaging, the open-circuit-failure-type gas discharge tube can be directly welded on a PCB (Printed Circuit Board).In the case ofchip packaging, the open-circuit-failure-type gas discharge tube can be directly welded on a PCB board or fixed by a metal fixture which is directly welded on a PCB board.

As shown in Fig. 4, the alarm indication circuit in the present embodiment includes a first current-limiting module 21, a second current-limiting module 22, and an alarm module 23.The first current-limiting module 21 and the second current-limiting module 22 are connected in series.One end of the alarm module 23 is connected between the first current-limiting module 21 and the second current-limiting module 22, and another end thereof is grounded.

When a power line is not bonded onthe first current-limiting module 21 and the second current-limiting module 22, thethreshold switch is in a cut-off state, which can ensure that the alarm indication circuit is in a high-impedance state. When a power line is bonded, a current flows through the threshold switch and is clamped, and the alarm module 23 outputs an alarm.At this time, alamp can be illuminated for alarmwithout the need of adding an external power supply such as -48VIn one embodiment, the first current-limiting module 21 includes a first current-limiting resistor and a first threshold switch connected in series; the second current-limiting module 22 includes a second current-limiting resistor and a second threshold switch connected in series;andthe alarm module 23 includes an alarm indicating lamp sub-module.

When a voltage cross two ends of the alarm indication circuit is smaller than or equal to a voltage threshold, the first threshold switch and the second threshold switch are in a high-impedance state to avoid an effect of the indication circuit on signal quality on the subscriber line.When an external overvoltage is bonded on thesubscriber line, the voltage acrosstwo ends of the alarm indication circuit is greater than the voltage threshold; the first threshold switch and the second threshold switch are switched to a conductive state;the current is limited by means of the first current-limiting resistor and the second current-limiting resistor, and a milliamp-level current is formed between the subscriber line and protective ground, so that the alarm module outputs an alarm signal (for example, illuminating an LED (light-emitting diode) indicating lamp). Compared with an existing security unit, the security unit of the present disclosure does not need an external DC power supply for illuminating the LED indicating lamp.

In one embodiment, the first current-limiting module 21 includes a first current-limiting resistor; the second current-limiting module 22 includes a second current-limiting resistor; and the alarm module 23 includes a threshold switch and an alarm indicating lamp sub-module connected in series.

In such an embodiment, the threshold switch is located in the alarm module 23, which saves one threshold switch and saves costs.The first current-limiting resistor and the second current-limiting resistor have a current-limiting effect on the alarm indication circuit, and protect the alarm module 23 from damage caused by a large current surge.When the voltage across two ends of the alarm indication circuit is greater than a voltage threshold, the threshold switch is switched from a high-impedance state to a conductive state, anda milliamp-level current flows intothe alarm indicating lampsub-module and enables the alarm indicating lampin the alarm indicating lampsub-module to be illuminated.The above threshold switch maybeformed from an overvoltage protector, for example, a semiconductor overvoltage protector (including TSS (Thyristor Surge Suppressor)), or a transient suppression diode, a varistor, or a zener diode.

In one embodiment, the alarm indicating lampsub-module includes one or more alarm indicating lamps connected in parallel.

The alarm indicating lamps may be LED indicating lamps, or may be neon bulbs, or other forms of indicating lamps.

In one embodiment, the alarm module further includes an alarm signal output sub-module.The alarm signal output sub-module is connected in parallel with the alarm indicating lamp sub-module, and outputs at least one of a DC-level signal or a pulse-level signal.

By outputting at least one of theDC-level signal and thepulse-level signal, an alarm signal can be output to an external device.For example, the alarm signal can be output to a monitoring device, and alarm information is displayed and recorded by the monitoring device.

In one embodiment, the alarm signal output sub-module includes an optocoupler. The optocoupler is connected in parallel with the alarm indicating lamp sub-module and outputs a pulse-level signal.

In one embodiment, the alarm signal output sub-module includes a rectifier circuit and an optocoupler. The rectifier circuit includes a diode and a capacitor. An anode of the diode is connected witha non-ground terminal of the alarm indicating lamp sub-module. Acathodeof the diode is connected withan end of the capacitor. The capacitor is connected in parallel with the optocoupler. One end of the capacitor is connected with the cathode of the diode, and another end thereof is grounded. The optocoupler outputs a DC-level signal.

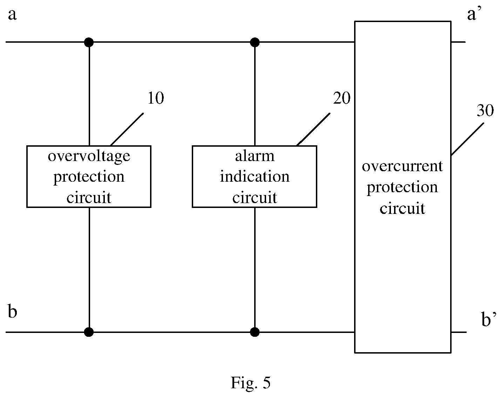

As shown in Fig. 5, in one embodiment, the security unit may further include an overcurrent protection circuit 30. The overcurrent protection circuit 30 includes a first overcurrent protection module and a second overcurrent protection module. One end of the first overcurrent protection module is connected with an external line terminalof the security unit and an end of the overvoltage protection circuit and an end of the alarm indication circuit, and another end of the first overcurrent protection module is connected with an internal line terminal of the security unit. One end of the second overcurrent protection module is connected withanother external line terminal of the security unit and another end of the overvoltage protection circuit and another end of the alarm indication circuit, and another end of the second overcurrent protection module is connected withanother internal line terminalof the security unit.

The first overcurrent protection module and the second overcurrent protection module are used to, limit an external hazardous current to flow into a protected subscriber terminal when anexternal hazardous voltage continues to appear, and meanwhile decouple the security unit from a protected terminal secondary protection circuit in the case of a rapid pulse interference such as a surge.

In one embodiment, the first overcurrent protection module includes a first positive temperature coefficient thermistor, and the second overcurrent protection module includes a second positive temperature coefficient thermistor.

In the case of a normal voltage, the positive temperature coefficient thermistor are in a low-impedance state. When an input voltage on the security unit exceeds a limit, a current flowing through the positive temperature coefficient thermistors increases accordinglyand temperature increases.In this case, the positive temperature coefficient thermistorsswitch to a high-impedance state and play a role in current-limiting,thusprotecting the subscriber terminal.

In the case where the protected subscriber terminal can meet requirements of power line bonding and induction, the overcurrent protection circuit 30 can be omitted.

Due to the fact that the open-circuit-failure-type gas discharge tube can keep heated only for a very short time, abimetallic strip is not required as a switch to cut off the main circuit, andthe alarm indication circuit can input an alarm signal when a hazardous voltage is present;therefore,components such as abimetallic strip,a spring and so on can be omitted.All components in the security unit can be welded on a PCB board, and the security unit isthus more suitable for mass production.

The present disclosure is described below by way of application examples.

### Application Example 1

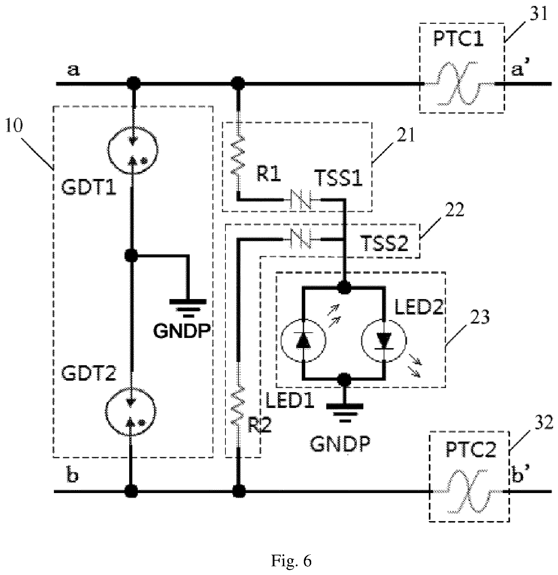

As shown in Fig. 6, terminal a and terminal b are external line terminals, which connect an outdoor subscriber line, and terminal a' and terminal b' are internal lineterminals which,after being protected by a security unit,connecta subscriber line of a central office device. The security unit in this application example includes an overvoltage protection circuit 10 an alarm indication circuit 20 connected in parallel, and an overcurrent protection circuit 30.

Among them, the overvoltage protection circuit 10 includesopen-circuit-failure-type gas discharge tubes GDT1 and GDT2.

Due to the use of the open-circuit-failure-type gas discharge tube, even in the case of such asbonding a power line, a low-temperature sealing adhesive in the open-circuit-failure-type gas discharge tube can be quickly melted, enabling the open-circuit-failure-type gas discharge tubeto be in an open-circuit state.Bursting of the gas discharge tube due to heating and burning of the security unit can thus be avoided.

The alarm indication circuit includes a first current-limiting module 21, a second current-limiting module 22, and an alarm module 23.The first current-limiting module 21 includes a first current-limiting resistor R1 and a first threshold switch (in this application example, as an example for description, the first threshold switch is a Thyristor Surge Suppressor, represented as TSS1).The second current-limiting module 22 includes a second current-limiting resistor R2 and a second threshold switch (in this application example, as an example for description, the second threshold switch is a Thyristor Surge Suppressor, represented as TSS2).The alarm module 23 includes an alarm indicating lamp sub-module.The alarm indicating lamp sub-module includes light-emitting diodes LED1 and LED2 connected in parallel with each other.An anode and a cathode of the LED1 and an anode and a cathode of the LED2are in oppositeorders, so that when the alarm indication circuitis conductingin whichever direction, there is always oneindicating lampthat is illuminated. Values of the first current-limiting resistor R1 and the second current-limiting resistor R2 can be several hundred K ohms, which vary according to a value of a voltage on the subscriber line. A principle concerning these valuesis that when an overvoltage occurs,a milliamp-level currentcan be enabled to flow through the alarm indicating lamp in the alarm indicating lamp sub-module, so that the alarm indicating lamp can be illuminated.

Considering that an outdoor subscriber line is usually located in a relatively complexenvironment and it often happens that a subscriber line collides withan AC power line,in the case where a power line is bonded on subscriber line a or subscriber line b, the TSS component is in a critical conductive state or conductive state. By providing the current-limiting resistor R1 or R2,a milliamp-level current flows through the LED to protective ground GNDP, illuminating the LED, which is convenient for a maintenance person to timely find and locate a terminal for bonding the power line. The threshold switchcan also be replaced with a transient suppression diode, a varistor, or a zener diode.Since the power line is an AC power supply, the LED indicating lamps can also be reduced to one, or replaced with neon bulbs.

In the case that thesubscriber lineworks normally, the open-circuit-failure-type gas discharge tube is in a high-impedance state. An operation voltage across the threshold switches TSS1 and TSS2 is greater than a ringing current and a feed voltage. At this time, the semiconductor threshold switch is in a high-impedance state, which avoids effectsof the indication circuit on a signal on the subscriber line.

The overcurrent protection circuit 30 includes a first overcurrent protection module 31 and a second overcurrent protection module 32.The first overcurrent protection module 31 includes a positive temperature coefficient thermistor PTC1. The second overcurrent protection module 32 includes a positive temperature coefficient thermistor PTC2.

By adopting the positive temperature coefficient thermistors PTC1 and PTC2 in the overcurrent protection circuit 30, when an external hazardous current continues to appear,the external hazardous current can be limited to flow into aprotectedsubscriber terminal of acentral office device.In the case where the protected subscriber terminal can meet requirements of power line bonding and induction, the overcurrent protection circuit 30 can be omitted.

When a lightning surge occurs on anexternal subscriber line a or b, the open-circuit-failure-type gas discharge tube can quickly discharge a hazardous current through the protective ground GNDP, and the positive temperature coefficient thermistors PTC1 and PTC2 can decouple the security unitfrom aprotected terminal secondary protectioncircuit, ensuring that most of hazardous energy can be discharged through the gas discharge tube.

### Application Example 2

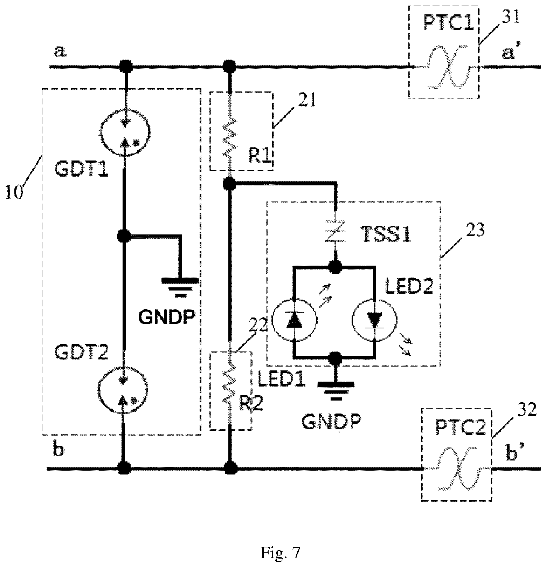

This application example provides a security unit. As shown in Fig. 7, the security unit in this application example includes an overvoltage protection circuit 10 and an alarm indication circuit 20 connected in parallel, and an overcurrent protection circuit 30.

Among them, the overvoltage protection circuit 10 includes open-circuit-failure-type gas discharge tubes GDT1 and GDT2.

Due to the use of the open-circuit-failure-type gas discharge tube, even in the case of such as bonding a power line, a low-temperature sealing adhesive in the open-circuit-failure-type gas discharge tube can be quickly melted, enabling the open-circuit-failure-type gas discharge tube to be in an open-circuit state.Bursting of the gas discharge tube due to heating and burning of the security unit can thus be avoided.

The alarm indication circuit includes a first current-limiting module 21, a second current-limiting module 22, and an alarm module 23.The first current-limiting module 21 includes a first current-limiting resistor R1, and the second current-limiting module 22 includes a second current-limiting resistorR2. The alarm module 23 includes a threshold switch TSS1 and an alarm indicating lamp sub-module.The alarm indicating lamp sub-module includes light-emitting diodes LED1 and LED2connected in parallel with each other.An anode and a cathode of the LED1 and an anode and a cathode of the LED2are in opposite orders, so that when the alarm indication circuit is turned onin whichever direction, there is always oneindicating lampthat is illuminated.The LED1 and LED2 each can be formedof a two-color indicating lamp.

This application example is a cost-reducing solution for Application Example 1. In this application example, only one semiconductor threshold switch TSS1 is used, which is suitable for an occasion where high impedance is not required for impedance of the subscriber line.During normal operation, the first current-limiting resistor R1 and the second current-limiting resistor R2 are connected in series on subscriber lines a and b.In the case thata power line is bonded on the subscriber line a or b, the threshold switch (in this application example, as an example for description, the threshold switch is a Thyristor Surge Suppressor, represented as TSS1) is in a critical conductive state or conductive state, and a milliamp-level current flows through the LED1 and the LED2 to protective ground GNDP, illuminating the LED1 and the LED2, which is convenient for a maintenance person to timely find and locate a terminal for bonding the power line.The overcurrent protection circuit 30 includes a first overcurrent protection module 31 and a second overcurrent protection module 32.The first overcurrent protection module 31 includes a positive temperature coefficient thermistor PTC1, and the second overcurrent protection module 32 includes a positive temperature coefficient thermistor PTC2.

By adopting the positive temperature coefficient thermistors PTC1 and PTC2 in the overcurrent protection circuit 30, when an external hazardous current continues to appear,the external hazardous current can be limited to flow into a protected subscriber terminal of a central office device.In the case where the protected subscriber terminal can meet requirements of power line bonding and induction, the overcurrent protection circuit 30 can be omitted.

### Application Example 3

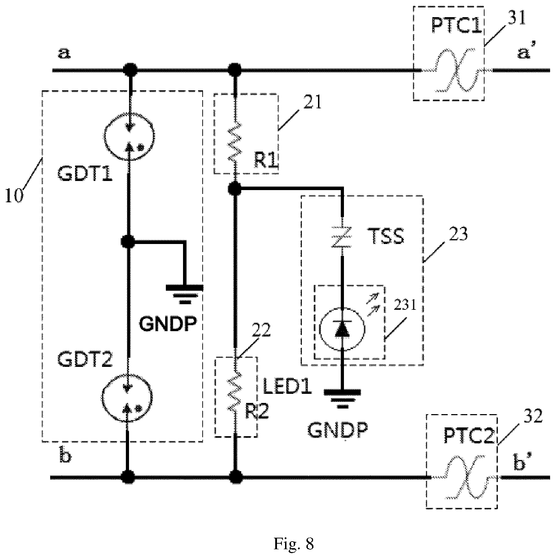

This application example provides a security unit. As shown in Fig. 8, the security unit in this application example includes an overvoltage protection circuit 10 and an alarm indication circuit 20 connected in parallel, and an overcurrent protection circuit 30.

Among them, the overvoltage protection circuit 10 includes open-circuit-failure-type gas discharge tubes GDT1 and GDT2.

Due to the use of the open-circuit-failure-type gas discharge tube, even in the case of such as bonding a power line, a low-temperature sealing adhesive in the open-circuit-failure-type gas discharge tube can be quickly melted, enabling the open-circuit-failure-type gas discharge tube to be in an open-circuit state.Bursting of the gas discharge tube due to heating and burning of the security unit can thus be avoided.

The alarm indication circuit includes a first current-limiting module 21, a second current-limiting module 22, and an alarm module 23.The first current-limiting module 21 includes a first current-limiting resistor R1, and the second current-limiting module 22 includes a second current-limiting resistor R2.The alarm module 23 includes a threshold switch (in this application example, as an example for description, the threshold switch is a Thyristor Surge Suppressor, represented as TSS) and an alarm indicating lamp sub-module 231.The alarm indicating lamp sub-module 231 includes a light-emitting diode LED1.

This application example is a further cost-reducing solution for Application Example 2. Since the power line is an AC power supply, it is feasible to use only one light-emitting diode LED as an alarm indicating lamp.

The overcurrent protection circuit 30 includes a first overcurrent protection module 31 and a second overcurrent protection module 32.The first overcurrent protection module 31 includes a positive temperature coefficient thermistor PTC1, and the second overcurrent protection module 32 includes a positive temperature coefficient thermistor PTC2.

By adopting the positive temperature coefficient thermistors PTC1 and PTC2 in the overcurrent protection circuit 30, when an external hazardous current continues to appear,the external hazardous current can be limited to flow into a protectedsubscriber terminal of acentral office device.In the case where the protected subscriber terminal can meet requirements of power line bonding and induction, the overcurrent protection circuit 30 can be omitted.

### Application Example 4

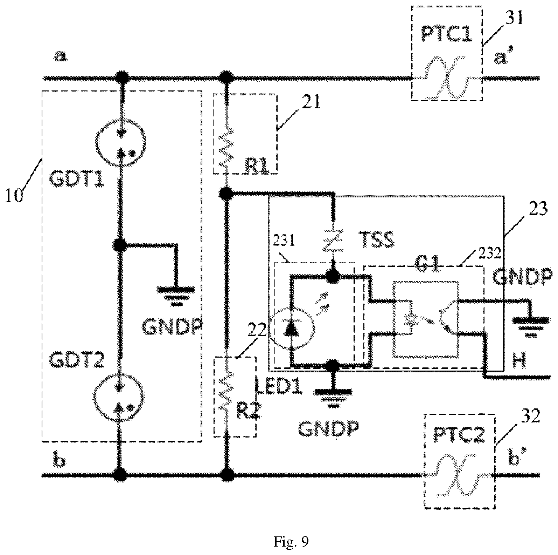

This application example provides a security unit. As shown in Fig. 9, the security unit in this application example includes an overvoltage protection circuit 10 and an alarm indication circuit 20 connected in parallel, and an overcurrent protection circuit 30.

Among them, the overvoltage protection circuit 10 includes open-circuit-failure-type gas discharge tubes GDT1 and GDT2.

Due to the use of the open-circuit-failure-type gas discharge tubes, even in the case of such as bonding a power line, a low-temperature sealing adhesive in the open-circuit-failure-type gas discharge tube can be quickly melted, enabling the open-circuit-failure-type gas discharge tube to be in an open-circuit state.Bursting of the gas discharge tube due to heating and burning of the security unit can thus be avoided.

The alarm indication circuit includes a first current-limiting module 21, a second current-limiting module 22, and an alarm module 23.The first current-limiting module 21 includes a first current-limiting resistor R1, and the second current-limiting module 22 includes a secondcurrent-limiting resistor R2.The alarm module 23 includes a threshold switch (in this application example, as an example for description, the threshold switch is a Thyristor Surge Suppressor, represented as TSS), an alarm indicating lamp sub-module 231, and an alarm signal output sub-module 232. The alarm indicating lamp sub-module 231 includes a light-emitting diode LED 1.The alarm signal output sub-module 232 is connected in parallel with the alarm indicating lamp sub-module 231.In this example, the alarm signal output sub-module 232 includes an optocoupler G1, which outputs a pulse-level signal.

This application example replaces one of the LED diodes in Application Example 1 with an optocoupler, which is suitable for an occasion requiring both alarm LED indication of power line bonding and the like and an alarm signal output.When an abnormal condition such as power line bonding or power line induction occurs, a 50Hz/60Hz pulse alarm signal can be output to a terminal H through the optocoupler.

The overcurrent protection circuit 30 includes a first overcurrent protection module 31 and a second overcurrent protection module 32.The first overcurrent protection module 31 includes a positive temperature coefficient thermistor PTC1, and the second overcurrent protection module 32 includes a positive temperature coefficient thermistor PTC2.

By adopting the positive temperature coefficient thermistors PTC1 and PTC2 in the overcurrent protection circuit 30, when an external hazardous current continues to appear,the external hazardous current can be limited to flow into a protectedsubscriber terminal of acentral office device.In the case where the protected subscriber terminal can meet requirements of power line bonding and induction, the overcurrent protection circuit 30 can be omitted.

### Application Example 5

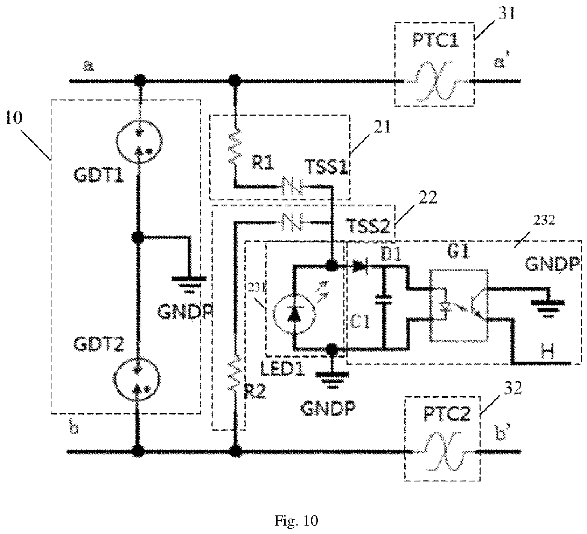

This application example provides a security unit. As shown in Fig. 10, the security unit in this application example includes an overvoltage protection circuit 10 and an alarm indication circuit 20 connected in parallel, and an overcurrent protection circuit 30.

Among them, the overvoltage protection circuit 10 includes open-circuit-failure-type gas discharge tubes GDT1 and GDT2.

Due to the use of the open-circuit-failure-type gas discharge tube, even in the case of such asbonding a power line, a low-temperature sealing adhesive in the open-circuit-failure-type gas discharge tube can be quickly melted, enabling the open-circuit-failure-type gas discharge tube to be in an open-circuit state.Bursting of the gas discharge tube due to heating and burning of the security unit can thus be avoided.

The alarm indication circuit includes a first current-limiting module 21, a second current-limiting module 22, and an alarm module 23.The first current-limiting module 21 includes a first current-limiting resistor R1 and a first threshold switch (in this application example, as an example for description,the first threshold switch is a Thyristor Surge Suppressor, represented as TSS1).The second current-limiting module 22 includes a second current-limiting resistor R2 and a second threshold switch (in this application example, an example for description,the second threshold switch is a Thyristor Surge Suppressor, represented as TSS2).The alarm module 23 includes an alarm indicating lamp sub-module 231 and an alarm signal output sub-module 232. The alarm indicating lamp sub-module 231 includes a light-emitting diode LED1.The alarm signal output sub-module 232 is connected in parallel with the alarm indicating lamp sub-module 231. In this example, the alarm signal output sub-module 232 includes a rectifier circuit and an optocoupler G1. The rectifier circuit includes a diode D1 and a capacitor C1. An anode of the diode D1 is connected with a non-ground terminal of the alarm indicating lamp sub-module 231, and a cathode of the diode D1 is connected with one end of the capacitor C1.The capacitor C1 is connected in parallel with the optocoupler G1. One end of the capacitor Clis connected with thecathode of the diode D1, and another end thereof is grounded. The optocoupler G1 outputs a DC-level signal.

This application example,on the basis of Application Example 4,adds a diode D1 and a capacitor C1 of a rectifier circuit. When an abnormal condition such as power line bonding or power line induction occurs, a voltage is rectified into a DC voltage by means of D1 and C1, enabling the optocoupler G1 to be conductive and tooutput a DC level alarm signal to a terminal H, just like a conventional security unit, with external addition of a pull-up resistor and a bias voltage.

The overcurrent protection circuit 30 includes a first overcurrent protection module 31 and a second overcurrent protection module 32.The first overcurrent protection module 31 includes a positive temperature coefficient thermistor PTC1, and the second overcurrent protection module 32 includes a positive temperature coefficient thermistor PTC2.

By adopting the positive temperature coefficient thermistors PTC1 and PTC2 in the overcurrent protection circuit 30, when an external hazardous current continues to appear,the external hazardous current can be limited to flow into a protectedsubscriber terminal of acentral office device.In the case where the protected subscriber terminal can meet requirements of power line bonding and induction, the overcurrent protection circuit 30 can be omitted.

### Industrial applicability

In the embodiments of the present disclosure, the overvoltage protection circuit in the security unit can meet reliability standards of such as related power lines and lightning surges. When a lightning surge and a surge currentoccur, the overvoltage protection circuitcan quickly discharge alarge current. When an inflow current is larger than a current threshold and duration thereof exceeds a time threshold, the overvoltage protection circuit switches to an open-circuit state, which can effectively prevent the risk of bursting of the gas discharge tube due to its getting conductive and hot caused by a gas breakdown as well as burning of the security unit.In the case of an abnormal hazardous voltage such as power line bonding or power line induction, the alarm indication circuit in the security unit can illuminate an indicating lamp withoutan external power supply such as -48V.In addition, all components of the security unit can be weldedon a printed board, anddevices such asa bimetallic strip and a spring are omitted, which further reduces the cost and is more suitable for mass production. The solutions of the embodiments of the present disclosure havegood industrial applicability.

## Claims

1. A security unit, comprising an overvoltage protection circuit (10) and an alarm indication circuit (20) connected in parallel, wherein:
an initial state of the overvoltage protection circuit (10) is a high-impedance state; the overvoltage protection circuit (10) switches to a conductive state when a voltage across two ends thereof is greater than a breakdown voltage, and switches to an open-circuit state when a current flowing thereinto is greater than a current threshold and duration of the current exceeds a time threshold;
the alarm indication circuit (20) outputs an alarm signal when a voltage across two ends thereof is greater than a voltage threshold;
**characterized in that**:
the alarm indication circuit (20) comprises a first current-limiting module (21), a second current-limiting module (22), and an alarm module (23);
the first current-limiting module (21) and the second current-limiting module (22) are connected in series; and
one end of the alarm module (23) is connected between the first current-limiting module(21) and the second current-limiting module (22), and another end thereof is grounded.

2. The security unit according to claim 1, **characterized in that** the overvoltage protection circuit (10) comprises at least one open-circuit-failure-type gas discharge tube.

3. The security unit according to claim 2, **characterized in that**
the overvoltage protection circuit (10) comprises two two-electrode open-circuit-failure-type gas discharge tubes connected in series (GT1, GT2), and the connection point between the two two-electrode open-circuit-failure-type gas discharge tubes (GDT1, GDT2) is grounded; or,
the overvoltage protection circuit (10) comprises a three-electrode open-circuit-failure-type gas discharge tube.

4. The security unit according to claim 1, **characterized in that** the first current-limiting module (21) comprises a first current-limiting resistor (R1) and a first threshold switch (TSS1) connected in series; the second current-limiting module comprises a second current-limiting resistor (R2) and a second threshold switch (TSS2) connected in series; and the alarm module (23) comprises an alarm indicating lamp sub-module (231).

5. The security unit according to claim 1, **characterized in that** the first current-limiting module (21) comprises a first current-limiting resistor (R1); the second current-limiting module (22) comprises a second current-limiting resistor (R2); and the alarm module (23) comprises a threshold switch (TSS) and an alarm indicating lamp sub-module (231) connected in series.

6. The security unit according to claim 4 or 5, **characterized in that** the alarm indicating lamp sub-module (231) comprises one or more alarm indicating lamps (LED1, LED2) connected in parallel with one another.

7. The security unit according to claim 4 or 5, **characterized in that** the alarm module (23) further comprises an alarm signal output sub-module (232), the alarm signal output sub-module (232) is connected in parallel with the alarm indicating lamp sub-module (231) and outputs one of a DC-level signal and a pulse-level signal.

8. The security unit according to claim 7, **characterized in that** the alarm signal output sub-module (232)comprises an optocoupler (G1), the optocoupler (G1) is connected in parallel with the alarm indicating lamp sub-module (231) and outputs a pulse-level signal.

9. The security unit according to claim 7, **characterized in that** the alarm signal output sub-module (232) comprises a rectifier circuit and an optocoupler (G1),
the rectifier circuit comprises a diode (D1) and a capacitor (C1), an anode of the diode (D1) is connected with a non-ground terminal of the alarm indicating lamp sub-module (231), and a cathode of the diode (D1)is connected with one end of the capacitor (C1); the capacitor (C1) is connected in parallel with the optocoupler (D1); one end of the capacitor (C1) is connected with the cathode of the diode (D1), and another end thereof is grounded; and
the optocoupler (G1) outputs a DC-level signal.

10. The security unit according to any one of claims 1 to 5, **characterized in that** the security unit further comprising an overcurrent protection circuit (30), the overcurrent protection circuit (30) includes a first overcurrent protection module (31) and a second overcurrent protection module (32),
one end of the first overcurrent protection module (31) is connected with an external line terminal (a) of the security unit and an end of the overvoltage protection circuit (10) and an end of the alarm indication circuit (20), and another end of the first overcurrent protection module (31) is connected with an internal line terminal (a') of the security unit; and
one end of the second overcurrent protection module (32) is connected with another external line terminal (b) of the security unit and another end of the overvoltage protection circuit (10) and another end of the alarm indication circuit (20), and another end of the second overcurrent protection module (32) is connected with another internal line terminal (b') of the security unit.

11. The security unit according to claim 10, **characterized in that** the first overcurrent protection module (31) comprises a first positive temperature coefficient thermistor (PTC1), and the second overcurrent protection module (32) comprises a second positive temperature coefficient thermistor (PTC2).

## Patentansprüche

1. Sicherungseinheit, umfassend eine Überspannungsschutzschaltung (10) und eine parallel angeschlossene Alarmanzeigeschaltung (20), worin:
ein Anfangszustand der Überspannungsschutzschaltung (10) ein hochohmiger Zustand ist; die Überspannungsschutzschaltung (10) auf einen leitenden Zustand wechselt, wenn eine Spannung durch zwei Enden davon größer ist als eine Durchbruchspannung, und auf einen Leerlauf-Zustand wechselt, wenn ein Strom, der darin fließt, größer ist als ein Stromschwellenwert und die Dauer des Stroms einen Zeitschwellenwert überschreitet;
die Alarmanzeigeschaltung (20) ein Alarmsignal ausgibt, wenn eine Spannung durch zwei Enden davon größer ist als ein Spannungsschwellenwert;
**dadurch gekennzeichnet, dass**:
die Alarmanzeigeschaltung (20) ein erstes Strombegrenzungsmodul (21), ein zweites Strombegrenzungsmodul (22) und ein Alarmmodul (23) umfasst;
das erste Strombegrenzungsmodul (21) und das zweite Strombegrenzungsmodul (22) in Serie angeschlossen sind; und
ein Ende des Alarmmoduls (23) zwischen dem ersten Strombegrenzungsmodul (21) und dem zweiten Strombegrenzungsmodul (22) angeschlossen ist, und ein anderes Ende davon geerdet ist.

2. Sicherungseinheit nach Anspruch 1, **dadurch gekennzeichnet, dass** die Überspannungsschutzschaltung (10) zumindest eine Gasentladungsröhre des offenen-Stromkreis-Fehler-Typs umfasst.

3. Sicherungseinheit nach Anspruch 2, **dadurch gekennzeichnet, dass**
die Überspannungsschutzschaltung (10) zwei Gasentladungsröhren des offenen-Stromkreis-Fehler-Typs mit zwei Elektroden umfasst, die in Serie angeschlossen sind (GT1, GT2), und der Anschlusspunkt zwischen den zwei Gasentladungsröhren des offenen-Stromkreis-Fehler-Typs mit zwei Elektroden (GDT1, GDT2) geerdet ist; oder
die Überspannungsschutzschaltung (10) eine Gasentladungsröhre des offenen-Stromkreis-Fehler-Typs mit drei Elektroden umfasst.

4. Sicherungseinheit nach Anspruch 1, **dadurch gekennzeichnet, dass** das erste Strombegrenzungsmodul (21) einen ersten Strombegrenzungswiderstand (R1) und einen ersten Schwellenwertschalter (TSS 1) umfasst, die in Serie angeschlossen sind; das zweite Strombegrenzungsmodul einen zweiten Strombegrenzungswiderstand (R2) und einen zweiten Schwellenwertschalter (TSS2) umfasst, die in Serie angeschlossen sind; und das Alarmmodul (23) ein Alarmanzeigelampe-Untermodul (231) umfasst.

5. Sicherungseinheit nach Anspruch 1, **dadurch gekennzeichnet, dass** das erste Strombegrenzungsmodul (21) einen ersten Strombegrenzungswiderstand (R1) umfasst; das zweite Strombegrenzungsmodul (22) einen zweiten Strombegrenzungswiderstand (R2) umfasst, und das Alarmmodul (23) einen Schwellenwertschalter (TSS) und ein Alarmanzeigelampe-Untermodul (231) umfasst, die in Serie angeschlossen sind.

6. Sicherungseinheit nach Anspruch 4 oder 5, **dadurch gekennzeichnet, dass** das Alarmanzeigelampe-Untermodul (231) eine oder mehrere Alarmanzeigelampen (LED1, LED2) umfasst, die miteinander parallel angeschlossen sind.

7. Sicherungseinheit nach Anspruch 4 oder 5, **dadurch gekennzeichnet, dass** das Alarmmodul (23) ferner ein Alarmsignalausgabe-Untermodul (232) umfasst, das Alarmsignalausgabe-Untermodul (232) mit dem Alarmanzeigelampe-Untermodul (231) parallel angeschlossen ist und eines von einem GS-Pegelsignal und einem Impulspegelsignal ausgibt.

8. Sicherungseinheit nach Anspruch 7, **dadurch gekennzeichnet, dass** das Alarmsignalausgabe-Untermodul (232) einen Optokoppler (G1) umfasst, der Optokoppler (G1) mit dem Alarmanzeigelampe-Untermodul (231) parallel angeschlossen ist und ein Impulspegelsignal ausgibt.

9. Sicherungseinheit nach Anspruch 7, **dadurch gekennzeichnet, dass** das Alarmsignalausgabe-Untermodul (232) eine Gleichrichterschaltung und einen Optokoppler (G1) umfasst,
die Gleichrichterschaltung eine Diode (D1) und einen Kondensator (C1) umfasst, eine Anode der Diode (D1) mit einem Nicht-Erd-Anschluss des Alarmanzeigelampe-Untermoduls (231) angeschlossen ist, und eine Kathode der Diode (D1) mit einem Ende des Kondensators (C1) angeschlossen ist; der Kondensator (C1) mit dem Optokoppler (G1) parallel angeschlossen ist; ein Ende des Kondensators (C1) mit der Kathode der Diode (D1) angeschlossen ist, und ein anderes Ende davon geerdet ist; und
der Optokoppler (G1) ein GS-Pegelsignal ausgibt.

10. Sicherungseinheit nach einem der Ansprüche 1 bis 5, **dadurch gekennzeichnet, dass** die Sicherungseinheit ferner eine Überstromschutzschaltung (30) umfasst, die Überstromschutzschaltung (30) ein erstes Überstromschutzmodul (31) und ein zweites Überstromschutzmodul (32) umfasst,
ein Ende des ersten Überstromschutzmoduls (31) mit einem äußeren Leitungsanschluss (a) der Sicherungseinheit und einem Ende der Überspannungsschutzschaltung (10) und einem Ende der Alarmanzeigeschaltung (20) angeschlossen ist, und ein anderes Ende des ersten Überstromschutzmoduls (31) mit einem inneren Leitungsanschluss (a') der Sicherungseinheit angeschlossen ist; und
ein Ende des zweiten Überstromschutzmoduls (32) mit einem anderen äußeren Leitungsanschluss (b) der Sicherungseinheit und einem anderen Ende der Überspannungsschutzschaltung (10) und einem anderen Ende der Alarmanzeigeschaltung (20) angeschlossen ist, und ein anderes Ende des zweiten Überstromschutzmoduls (32) mit einem anderen inneren Leitungsanschluss (b') der Sicherungseinheit angeschlossen ist.

11. Sicherungseinheit nach Anspruch 10, **dadurch gekennzeichnet, dass** das erste Überstromschutzmodul (31) einen ersten Thermistor mit positivem Temperaturkoeffizienten (PTC1) umfasst und das zweite Überstromschutzmodul (32) einen zweiten Thermistor mit positivem Temperaturkoeffizienten (PTC2) umfasst.

## Revendications

1. Unité de sécurité, comprenant un circuit de protection contre les surtensions (10) et un circuit d'indication d'alarme (20) connectés en parallèle, dans laquelle :
un état initial du circuit de protection contre les surtensions (10) est un état de haute impédance ; le circuit de protection contre les surtensions (10) passe à un état conducteur lorsqu'une tension aux deux extrémités de celui-ci est supérieure à une tension de claquage, et passe à un état de circuit ouvert lorsqu'un courant qui y circule est supérieur à un seuil de courant et que la durée du courant dépasse un seuil de temps ;
le circuit d'indication d'alarme (20) émet un signal d'alarme lorsqu'une tension aux deux extrémités de celui-ci est supérieure à un seuil de tension ;
**caractérisée en ce que** : le circuit d'indication d'alarme (20) comprend un premier module de limitation de courant (21), un second module de limitation de courant (22) et un module d'alarme (23) ;
le premier module de limitation de courant (21) et le second module de limitation de courant (22) sont connectés en série ; et
une extrémité du module d'alarme (23) est connectée entre le premier module de limitation de courant (21) et le second module de limitation de courant (22), et une autre extrémité de celui-ci est mise à la terre.

2. Unité de sécurité selon la revendication 1, **caractérisée en ce que** le circuit de protection contre les surtensions (10) comprend au moins un tube à décharge gazeuse de type à défaillance en circuit ouvert.

3. Unité de sécurité selon la revendication 2, **caractérisée en ce que** :
le circuit de protection contre les surtensions (10) comprend deux tubes à décharge gazeuse de type à défaillance en circuit ouvert à deux électrodes connectés en série (GT1, GT2), et le point de connexion entre les deux tubes à décharge gazeuse de type à défaillance en circuit ouvert à deux électrodes (GDT1, GDT2) est mis à la terre ; ou,
le circuit de protection contre les surtensions (10) comprend un tube à décharge gazeuse de type à défaillance en circuit ouvert à trois électrodes.

4. Unité de sécurité selon la revendication 1, **caractérisée en ce que** le premier module de limitation de courant (21) comprend une première résistance de limitation de courant (R1) et un premier commutateur de seuil (TSS1) connectés en série ; le second module de limitation de courant comprend une seconde résistance de limitation de courant (R2) et un second commutateur de seuil (TSS2) connectés en série ; et le module d'alarme (23) comprend un sous-module de lampe d'indication d'alarme (231).

5. Unité de sécurité selon la revendication 1, **caractérisée en ce que** le premier module de limitation de courant (21) comprend une première résistance de limitation de courant (R1) ; le second module de limitation de courant (22) comprend une seconde résistance de limitation de courant (R2) ; et le module d'alarme (23) comprend un commutateur de seuil (TSS) et un sous-module de lampe d'indication d'alarme (231) connectés en série.

6. Unité de sécurité selon la revendication 4 ou 5, **caractérisée en ce que** le sous-module de lampe d'indication d'alarme (231) comprend une ou plusieurs lampes d'indication d'alarme (LED1, LED2) connectées en parallèle les unes aux autres.

7. Unité de sécurité selon la revendication 4 ou 5, **caractérisée en ce que** le module d'alarme (23) comprend en outre un sous-module de sortie de signal d'alarme (232), le sous-module de sortie de signal d'alarme (232) est connecté en parallèle avec le sous-module de lampe d'indication d'alarme (231) et sort l'un d'un signal de niveau CC et d'un signal de niveau d'impulsion.

8. Unité de sécurité selon la revendication 7, **caractérisée en ce que** le sous-module de sortie de signal d'alarme (232) comprend un optocoupleur (G1), l'optocoupleur (G1) est connecté en parallèle avec le sous-module de lampe d'indication d'alarme (231) et émet un signal de niveau d'impulsion.

9. Unité de sécurité selon la revendication 7, **caractérisée en ce que** le sous-module de sortie de signal d'alarme (232) comprend un circuit redresseur et un optocoupleur (G1),
le circuit redresseur comprend une diode (D1) et un condensateur (C1), une anode de la diode (D1) est connectée à une borne non mise à la terre du sous-module de lampe d'indication d'alarme (231), et une cathode de la diode (D1) est connectée à une extrémité du condensateur (C1) ; le condensateur (C1) est connecté en parallèle avec l'optocoupleur (D1) ; une extrémité du condensateur (C1) est connectée à la cathode de la diode (D1), et une autre extrémité de celle-ci est mise à la terre ; et
l'optocoupleur (G1) émet un signal de niveau CC.

10. Unité de sécurité selon l'une quelconque des revendications 1 à 5, **caractérisée en ce que** l'unité de sécurité comprend en outre un circuit de protection contre les surintensités (30), le circuit de protection contre les surintensités (30) comprend un premier module de protection contre les surintensités (31) et un second module de protection contre les surintensités (32),
une extrémité du premier module de protection contre les surintensités (31) est connectée à une borne de ligne externe (a) de l'unité de sécurité et une extrémité du circuit de protection contre les surtensions (10) et une extrémité du circuit d'indication d'alarme (20), et une autre extrémité du premier module de protection contre les surintensités (31) est connectée à une borne de ligne interne (a') de l'unité de sécurité ; et
une extrémité du second module de protection contre les surintensités (32) est connectée à une autre borne de ligne externe (b) de l'unité de sécurité et une autre extrémité du circuit de protection contre les surtensions (10) et une autre extrémité du circuit d'indication d'alarme (20), et une autre extrémité du second module de protection contre les surintensités (32) est reliée à une autre borne de ligne interne (b') de l'unité de sécurité.

11. Unité de sécurité selon la revendication 10, **caractérisée en ce que** le premier module de protection contre les surintensités (31) comprend une première thermistance à coefficient de température positif (PTC1), et le second module de protection contre les surintensités (32) comprend une seconde thermistance à coefficient de température positif (PTC2).
